# EUROPEAN PATENT APPLICATION

(11) **EP 3 206 233 A1**
(43) Date of publication of application: **16.08.2017**
(21) Application number: 17155662.4
(22) Date of filing: 10.02.2017
(51) Int. Cl.: H01L 31/0745, H01L 31/18

(54) **SOLAR CELL AND METHOD OF MANUFACTURING THE SAME**

(30) Priority: 12.02.2016 KR 20160016465; 03.02.2017 KR 20170015443
(71) Applicant: LG ELECTRONICS INC., Yeongdeungpo-gu Seoul, 07336 (KR)
(72) Inventor: CHUNG, Indo, 08592 Seoul (KR); NAM, Jeongbeom, 08592 Seoul (KR); YANG, Juhong, 08592 Seoul (KR)
(74) Representative: Katérle, Axel

(57) **Abstract**

A method of manufacturing a solar cell is disclosed. The method includes forming a control passivation layer on a back surface of a semiconductor substrate containing impurities of a first conductivity type, forming an emitter region containing impurities of a second conductivity type opposite the first conductivity type and a back surface field region containing impurities of the first conductivity type on the control passivation layer, forming a passivation layer on the emitter region and the back surface field region, forming first and second openings in the passivation layer by using a pulse type laser having a continuously uniform intensity, forming a first electrode electrically and physically connected to the emitter region through the first opening, and forming a second electrode electrically and physically connected to the back surface field region through the second opening.

## Description

### CROSS-REFERENCE TO RELATED APPLICATION

This application claims priority to and the benefit of Korean Patent Application No. 10-2016-0016465 filed in the Korean Intellectual Property Office on February 12, 2016, and No. 10-2017-0015443 filed in the Korean Intellectual Property Office on February 3, 2017 the entire contents of which are incorporated herein by reference.

### BACKGROUND OF THE INVENTION

### Field of the Invention

Embodiments of the invention relate to a solar cell and a method of manufacturing the same.

### Description of the Related Art

Recently, as existing energy sources such as petroleum and coal are expected to be depleted, interests in alternative energy sources for replacing the existing energy sources are increasing. Hence, solar cells for generating electric energy from solar energy have been particularly spotlighted.

A silicon solar cell generally includes a semiconductor substrate and an emitter region, which are formed of semiconductors of different conductivity types, for example, a p-type and an n-type, and electrodes respectively connected to the semiconductor substrate and the emitter region. A p-n junction is formed at an interface between the semiconductor substrate and the emitter region.

When light is incident on the solar cell, a plurality of electron-hole pairs are generated in the semiconductors. The electron-hole pairs are separated into electrons and holes by a photovoltaic effect. The electrons move to the n-type semiconductor, for example, the emitter region, and the holes move to the p-type semiconductor, for example, the semiconductor substrate. Then, the electrons and the holes are collected by the electrodes electrically connected to the emitter region and the semiconductor substrate. The solar cell obtains electric power by connecting the electrodes using electric wires.

However, in this instance, the electrodes are positioned on the emitter region formed on the surface (i.e., an incident surface) of the semiconductor substrate, on which light is incident, as well as the surface of the semiconductor substrate, on which light is not incident. Therefore, an incident area of light decreases, and the efficiency of the solar cell is reduced.

Thus, a back contact solar cell, in which all of the electrodes collecting electrons and holes are positioned on a back surface of the semiconductor substrate, has been developed, so as to increase the incident area of light.

### SUMMARY OF THE INVENTION

Embodiments of the invention provide a solar cell having improved efficiency and a method of manufacturing the same.

In one aspect, there is provided a method of manufacturing a solar cell including forming a control passivation layer on a back surface of a semiconductor substrate containing impurities of a first conductivity type; forming an emitter region containing impurities of a second conductivity type opposite the first conductivity type and a back surface field region containing impurities of the first conductivity type on the control passivation layer; forming a passivation layer on the emitter region and the back surface field region; forming first and second openings in the passivation layer by using a pulse type laser having a continuously uniform intensity; forming a first electrode electrically and physically connected to the emitter region through the first opening; and forming a second electrode electrically and physically connected to the back surface field region through the second opening.

The embodiments of the invention can form electrodes in a short time without a damage to the semiconductor substrate by continuously irradiating a laser with a uniform intensity, thereby further increasing efficiency of the solar cell.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention. In the drawings:
FIG. 1 illustrates a solar cell according to a first embodiment of the invention;
FIG. 2 is a schematic cross-sectional view taken along line II-II of FIG. 1;
FIGS. 3A to 3J sequentially illustrate a method of manufacturing a solar cell shown in FIGS. 1 and 2;
FIG. 4 illustrates configuration of a laser irradiation device;
FIG. 5 is a graph illustrating a parameter used in irradiation conditions of a pulse type laser generated in a laser irradiation device;
FIG. 6 illustrates a solar cell according to a second embodiment of the invention; and
FIG. 7 illustrates a solar cell according to a third embodiment of the invention.

### DETAILED DESCRIPTION OF THE EMBODIMENTS

Reference will now be made in detail to embodiments of the invention, examples of which are illustrated in the accompanying drawings. This invention may, however, be embodied in many different forms and should not be construed as limited to the embodiments set forth herein. Wherever possible, the same reference numbers will be used throughout the drawings to refer to the same or like parts. It will be noted that a detailed description of known arts will be omitted if it is determined that the detailed description of the known arts can obscure the embodiments of the invention.

In the drawings, the thickness of layers, films, panels, regions, etc., are exaggerated for clarity. It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, it will be understood that when an element such as a layer, film, region, or substrate is referred to as being "entirely" on other element, it may be on the entire surface of the other element and may not be on a portion of an edge of the other element.

In the following description, "front surface" may be one surface of a semiconductor substrate, on which light is directly incident, and "back surface" may be a surface opposite the one surface of the semiconductor substrate, on which light is not directly incident or reflective light may be incident.

In the following description, the fact that values (for example, lengths or widths) of two different components are substantially equal to each other means that the values are equal to each other within a margin of error of 10 % or less.

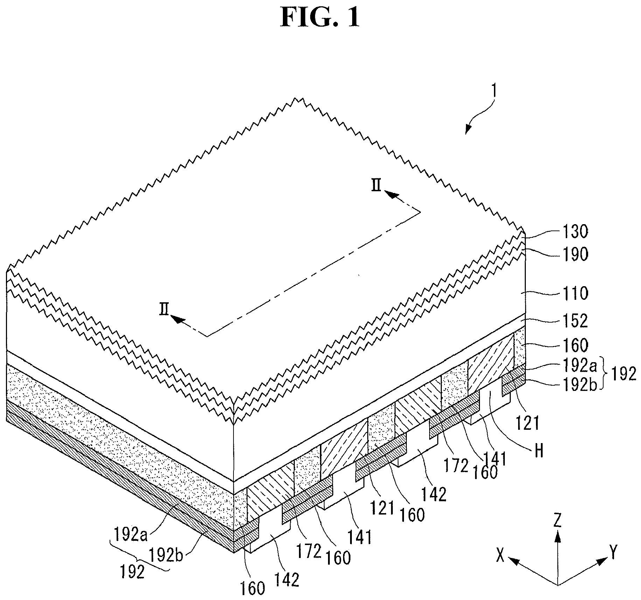

Embodiments of the invention will be described below with reference to FIGS. 1 to 7.

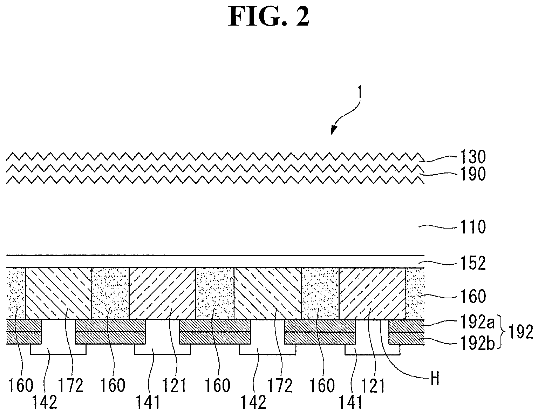

FIG. 1 illustrates a solar cell according to a first embodiment of the invention, and FIG. 2 is a schematic cross-sectional view taken along line II-II of FIG. 1.

As shown in FIGS. 1 and 2, a solar cell 1 according to a first embodiment of the invention may include a semiconductor substrate 110, an anti-reflection layer 130, a front passivation layer 190, a control passivation layer 152, a plurality of emitter regions 121, a plurality of back surface field regions 172, an intrinsic semiconductor layer 160, a back passivation layer 192, and a plurality of first and second electrodes 141 and 142.

In embodiments disclosed herein, the anti-reflection layer 130, the front passivation layer 190, the intrinsic semiconductor layer 160, and the control passivation layer 152 may be omitted, if desired or necessary. However, when the solar cell 1 includes them, efficiency of the solar cell 1 may be further improved. Thus, embodiments of the invention are described using the solar cell including the anti-reflection layer 130, the front passivation layer 190, the intrinsic semiconductor layer 160, and the control passivation layer 152 as an example.

The semiconductor substrate 110 includes a first surface (hereinafter, referred to as "front surface") and a second surface (hereinafter, referred to as "back surface"), and the front surface and the back surface are positioned opposite each other.

The semiconductor substrate 110 may have a first conductivity type, for example, an n-type, though not required. The semiconductor substrate 110 may be formed of single crystal silicon or polycrystalline silicon. For example, the semiconductor substrate 110 may be formed of a crystalline silicon wafer.

When the semiconductor substrate 110 is of the n-type, the semiconductor substrate 110 may be doped with impurities of a group V element, such as phosphorus (P), arsenic (As), and antimony (Sb). Alternatively, the semiconductor substrate 110 may be of a p-type. If the semiconductor substrate 110 is of the p-type, the semiconductor substrate 110 may be doped with impurities of a group III element, such as boron (B), gallium (Ga), and indium (In).

At least one of the front surface and the back surface of the semiconductor substrate 110 may form an uneven surface having a plurality of uneven portions, so as to increase an absorptance of light by reducing a reflectance of light at the front surface and the back surface of the semiconductor substrate 110. FIGS. 1 and 2 illustrate that only an edge of the semiconductor substrate 110 forms the uneven surface for the sake of brevity and ease of reading. However, in fact, the entire front surface of the semiconductor substrate 110 has the uneven surface, and the anti-reflection layer 130 and the front passivation layer 190 positioned on the front surface of the semiconductor substrate 110 each have the uneven surface.

For example, light incident on the front surface of the semiconductor substrate 110 having the plurality of uneven portions is incident on the inside of the semiconductor substrate 110 while being reflected several times by the uneven portions formed on the anti-reflection layer 130, the front passivation layer 190, and the surface of the semiconductor substrate 110. Hence, an amount of light reflected from the front surface of the semiconductor substrate 110 decreases, and an amount of light incident on the inside of the semiconductor substrate 110 increases. Further, surface areas of the semiconductor substrate 110, the anti-reflection layer 130, and the front passivation layer 190, on which light is incident, increase due to their uneven surface, and an amount of light incident on the semiconductor substrate 110 increases.

Unlike FIGS. 1 and 2, the back surface as well as the front surface of the semiconductor substrate 110 may have the uneven surface. However, embodiments of the invention describe that only the front surface of the semiconductor substrate 110 has the uneven surface, by way of example for the convenience of explanation.

As shown in FIGS. 1 and 2, the anti-reflection layer 130 is positioned on the front surface of the semiconductor substrate 110. The anti-reflection layer 130 increases selectivity of a predetermined wavelength band of light incident on the solar cell 1 and reduces a reflectance of light. Further, the anti-reflection layer 130 performs a passivation function that reduces a dangling bond existing at the front surface of the semiconductor substrate 110 and prevents or reduces carriers (for example, electrons or electrons) moving to the front surface of the semiconductor substrate 110 from being recombined and/or disappeared by the dangling bond.

Hence, the anti-reflection layer 130 can increase the efficiency of the solar cell 1. The anti-reflection layer 130 may be formed of a material including at least one of silicon oxide (SiOx), silicon oxynitride (SiOxNy), silicon nitride (SiNx), Zinc Oxide (ZnO), or aluminum zinc oxide (AZOx). However, embodiments of the invention are not limited thereto, and other materials may be used.

In embodiments of the invention, the anti-reflection layer 130 has a single-layered structure. However, the anti-reflection layer 130 may have a multi-layered structure, for example, a double-layered structure. In this instance, the passivation function of the anti-reflection layer 130 may be further strengthened, and photoelectric efficiency of the solar cell 1 may be further improved. The anti-reflection layer 130 may be omitted, if necessary or desired.

The anti-reflection layer 130 may be formed on the front surface of the semiconductor substrate 110 using various layer formation methods including a chemical vapor deposition (CVD) method, a plasma enhanced chemical vapor deposition (PECVD) method, and the like.

As shown in FIG. 1 and 2, the front passivation layer 190 is positioned on the front surface of the semiconductor substrate 110 and may be formed of non-crystalline semiconductor. For example, the front passivation layer 190 may be formed of intrinsic hydrogenated amorphous silicon (i-a-Si:H). The front passivation layer 190 can perform a passivation function, that converts a defect, for example, dangling bonds existing at and around the surface of the semiconductor substrate 110 into stable bonds using hydrogen (H) contained in the front passivation layer 190 and prevents or reduces carriers moving to the surface of the semiconductor substrate 110 from being recombined and/or disappeared by the defect. Thus, the front passivation layer 190 can reduce an amount of carriers lost at and around the surface of the semiconductor substrate 110. Hence, the front passivation layer 190 positioned on the front surface of the semiconductor substrate 110 can reduce an amount of carriers lost by the defect at and around the surface of the semiconductor substrate 110, thereby improving the efficiency of the solar cell 1.

As shown in FIG. 1 and 2, the front passivation layer 190 has a single-layered structure, but may have a multi-layered structure.

As shown in FIG. 1 and 2, the control passivation layer 152 is positioned on the entire back surface of the semiconductor substrate 110 while directly contacting the entire back surface. The control passivation layer 152 may include a dielectric material. Thus, the control passivation layer 152 may directly contact the back surface of the semiconductor substrate 110 formed of single crystal silicon and may pass carriers produced in the semiconductor substrate 110.

The control passivation layer 152 may pass carriers produced in the semiconductor substrate 110 and may perform a passivation function with respect to the back surface of the semiconductor substrate 110.

The control passivation layer 152 may be formed of a dielectric material including silicon carbide (SiCx) or silicon oxide (SiOx) having strong durability at a high temperature equal to or higher than 600 °C. In addition, the control passivation layer 152 may be formed of silicon nitride (SiNx), hydrogenated SiNx, aluminum oxide (AlOx), silicon oxynitride (SiON), or hydrogenated SiON. The control passivation layer 152 may have a thickness of 0.5 nm to 5 nm.

When the thickness of the control passivation layer 152 is equal to or greater than 0.5 nm, the passivation function of the control passivation layer 152 with respect to the surface of the semiconductor substrate 110 may be secured. When the thickness of the control passivation layer 152 is equal to or less than 5 nm, a tunneling effect for moving carriers to the emitter region 121 and the back surface field region 172 through the control passivation layer 152 may be secured.

When the thickness of the control passivation layer 152 exceeds 5 nm, an amount of carriers moving to the first and second electrodes 141 and 142 through the control passivation layer 152 may decrease because of a reduction in the tunneling effect. A short circuit current of the solar cell 1 according to the embodiment of the invention can be further improved by the passivation function and the tunneling effect of the control passivation layer 152.

As shown in FIGS. 1 and 2, the plurality of emitter regions 121 directly contacts a portion of a back surface of the control passivation layer 152 and extends in a first direction x. The emitter regions 121 may be formed of a polycrystalline silicon material of a second conductivity type opposite the first conductivity type. The emitter regions 121 may form a p-n junction along with the semiconductor substrate 110 with the control passivation layer 152 interposed therebetween. The emitter regions 121 may extend in the first direction x in parallel with the back surface field regions 172 and may alternate with the back surface field regions 172.

Because each emitter region 121 forms the p-n junction along with the semiconductor substrate 110, the emitter region 121 may be of the p-type. However, if the semiconductor substrate 110 is of the p-type unlike the embodiment described above, the emitter region 121 may be of the n-type. In this instance, separated electrons may move to the emitter regions 121, and separated holes may move to the back surface field regions 172.

Returning to the embodiment of the invention, when the emitter regions 121 are of the p-type, the emitter regions 121 may be doped with impurities of a group III element, such as B, Ga, and In. On the contrary, if the emitter regions 121 are of the n-type, the emitter regions 121 may be doped with impurities of a group V element, such as P, As, and Sb.

The emitter regions 121 may be formed by depositing the intrinsic semiconductor layer 160 on the back surface of the control passivation layer 152 and then diffusing impurities of the second conductivity type into the intrinsic semiconductor layer 160.

As shown in FIGS. 1 and 2, the plurality of back surface field regions 172 may be positioned at the back surface of the control passivation layer 152, on which the plurality of emitter regions 121 is not positioned, and may directly contact the back surface of the control passivation layer 152. The plurality of back surface field regions 172 may be extended in the same direction as the plurality of emitter regions 121. The back surface field regions 172 and the emitter regions 121 may be extended in the first direction x in parallel with each other and alternately disposed.

The back surface field regions 172 may be formed of a polycrystalline silicon material that is doped with impurities of the first conductivity type at a concentration higher than that of the semiconductor substrate 110. For example, when the semiconductor substrate 110 is doped with n-type impurities, each back surface field region 172 may be an n⁺-type region.

A potential barrier may be formed by a difference in an impurity concentration between the semiconductor substrate 110 and the back surface field regions 172. The back surface field regions 172 can prevent or reduce holes from moving to the back surface field regions 172 used as a moving path of electrons through the potential barrier and can make it easier for carriers (for example, electrons) to move to the back surface field regions 172.

Thus, the embodiment of the invention can reduce an amount of carriers lost by a recombination and/or a disappearance of electrons and holes at and around the back surface field regions 172 or at and around the first and second electrodes 141 and 142 and can accelerate a movement of electrons, thereby increasing an amount of electrons moving to the back surface field regions 172.

The intrinsic semiconductor layer 160 may be formed in a space between the emitter region 121 and the back surface field region 172 at the back surface of the control passivation layer 152 while directly contacting the back surface of the control passivation layer 152. The intrinsic semiconductor layer 160 may be formed of intrinsic polycrystalline silicon, which is not doped with impurities of the first conductivity type or impurities of the second conductivity type, unlike the emitter region 121 and the back surface field region 172.

As described above, the intrinsic semiconductor layer 160 may be formed in the space between the emitter region 121 and the back surface field region 172 at the back surface of the control passivation layer 152. In this instance, as shown in FIGS. 1 and 2, the intrinsic semiconductor layer 160 may be configured such that its both sides directly contact the side of the emitter region 121 and the side of the back surface field region 172, respectively.

The intrinsic semiconductor layer 160 may be formed on the back surface of the semiconductor substrate 110 using a stacking method, such as a CVD method and a PECVD method.

As shown in FIGS. 1 and 2, the plurality of first electrodes 141 may be respectively positioned on the plurality of emitter regions 121. The first electrode 141 may be extended along the emitter region 121 and may be electrically and physically connected to the emitter region 121. Hence, the first electrode 141 may collect carriers (for example, holes) moving to the corresponding emitter region 121.

The plurality of second electrodes 142 may be respectively positioned on the plurality of back surface field regions 172. The second electrode 142 may be extended along the back surface field region 172 and may be electrically and physically connected to the back surface field region 172. Hence, the second electrode 142 may collect carriers (for example, electrons) moving to the corresponding back surface field region 172.

The plurality of first and second electrodes 141 and 142 may be formed of a conductive material. For example, the plurality of first and second electrodes 141 and 142 may be formed of at least one conductive material selected from the group consisting of nickel (Ni), copper (Cu), silver (Ag), aluminum (Al), tin (Sn), zinc (Zn), indium (In), titanium (Ti), gold (Au), and a combination thereof. Other materials may be used. For example, a transparent conductive material such as transparent conductive oxide (TCO) may be used.

As shown in FIGS. 1 and 2, the back passivation layer 192 may include a first back passivation layer 192a contacting the back surface of the semiconductor substrate 110 and a second back passivation layer 192b contacting a back surface of the first back passivation layer 192a.

More specifically, the first back passivation layer 192a may be formed of silicon oxide (SiOx), and the second back passivation layer 192b may be formed of silicon nitride (SiNx).

A thickness of the back passivation layer 192 may be 50 nm to 100 nm in consideration of a passivation effect.

The back passivation layer 192 may include a plurality of openings H exposing a portion of each of the emitter region 121 and the back surface field region 172. A distance between the plurality of openings H may be 100 µm to 500 µm.

The distance between the plurality of openings H formed by irradiating a laser beam onto the semiconductor substrate 110 may be defined as described above. Namely, when the distance between the openings H is excessively small, an area of the semiconductor substrate 110, onto which the laser beam is irradiated, may excessively increase to deteriorate characteristics of the semiconductor substrate 110. When the distance between the openings H is excessively large, a fill factor FF of the solar cell 1 may be reduced.

Hence, the first back passivation layer 192a may be formed in a remaining area excluding a connecting portion of the first electrode 141 and the emitter region 121 and a connecting portion of the second electrode 142 and the back surface field region 172 from the back surface of the semiconductor substrate 110.

The first electrode 141 may be formed on a back surface of the emitter region 121 exposed through the opening H, and the second electrode 142 may be formed on a back surface of the back surface field region 172 exposed through the opening H.

Hence, the electrical and physical connection between the first electrodes 141 and the emitter regions 121 and the electrical and physical connection between the second electrodes 142 and the back surface field regions 172 may be performed through the plurality of openings H. The plurality of openings H may be formed without a mechanical damage to the solar cell 1 by continuously irradiating the laser with a uniform intensity using a laser process and etching the back passivation layer 192 in a short time.

The back passivation layer 192 may be formed to partially overlap the first and second electrodes 141 and 142.

The back passivation layer 192 insulates between the first and second electrodes 141 and 142. Further, the back passivation layer 192 performs a passivation function that reduces a dangling bond existing at the back surface of the semiconductor substrate 110 and prevents or reduces carriers (for example, electrons or electrons) moving to the back surface of the semiconductor substrate 110 from being recombined and/or disappeared by the dangling bond.

The back passivation layer 192 may be formed as a single layer including one of Al₂O₃, SiOxNy, SiOx and SiNx, or as a multi-layer including two or more of Al₂O₃, SiOxNy, SiOx and SiNx.

In embodiments of the invention, the plurality of openings H may be formed using a laser irradiation device 2.

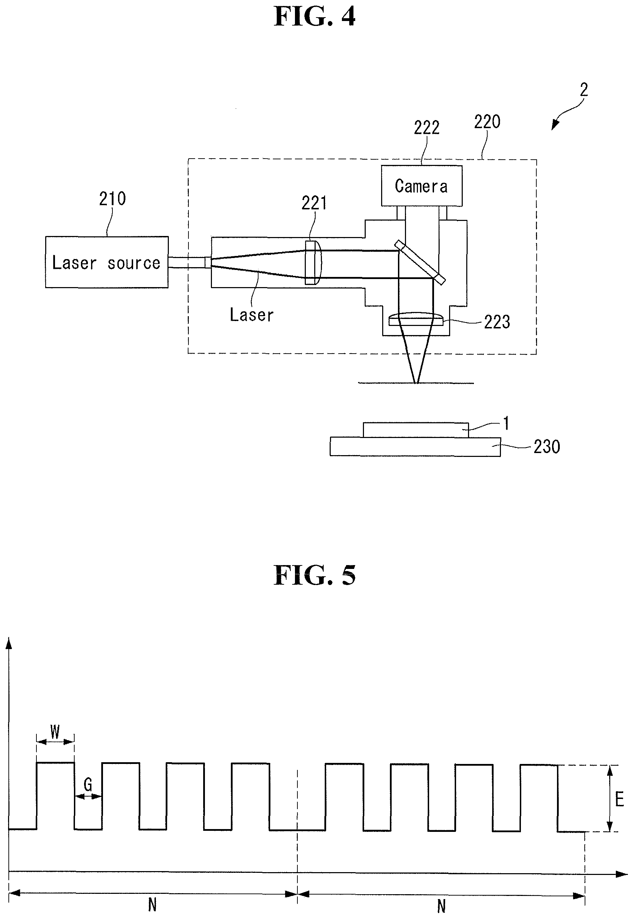

As shown in FIG. 4, the laser irradiation device 2 may include a laser source 210, an optical unit 220, and a transfer unit 230.

The laser source 210 generates cracks. For example, a green laser source, Nd/YAG laser source, and the like may be used.

The optical unit 220 may include a collimator 221 for adjusting a diameter, etc. of a laser, a camera 22, and a focusing part 223 for transferring the laser to a desired location.

As shown in FIG. 5, irradiation conditions of the laser may be controlled by parameters including a total energy E, a pulse width W, a pulse number N, a pulse gap G, etc. of the laser.

In embodiments of the invention, the energy E of the laser may be about 0.1 J/cm² to 3 J/ cm². When the laser energy E is less than about 0.1 J/cm², an etching process of the back passivation layer 192 may not be smoothly performed. When the laser energy E exceeds about 3 J/cm², the laser irradiation device 2 may be overloaded.

In this instance, the laser energy E may have the same intensity (i.e., a uniform intensity). In embodiments of the invention, the electrodes may be formed on the semiconductor substrate 110 by the laser energy E having the same intensity without a damage to the semiconductor substrate 110.

The pulse width W of the laser may be about 10 ps to 15 ps in consideration of efficiency of the etching process.

The pulse number N of the laser may be one to eight in consideration of efficiency of laser ablation, more preferably, two to four, but such is not required. In this instance, the pulse number N of the laser may have a repetition rate of a predetermined cycle. Namely, a pulse type laser having the same pulse width W and the same energy E may be successively generated. Further, the pulse gap G of the laser may be about 20 ns in consideration of the efficiency of laser ablation and an influence on life span of the laser irradiation device 2.

In embodiments of the invention, four pulses having the same energy E per cycle may be successively generated at uniform intervals of the pulse gap G.

Hence, in embodiments of the invention, a laser having a wavelength band of 1,064 nm at maximum may be generated.

The optical unit 220 may receive the pulse type laser from the laser source 210 and irradiate the pulse type laser onto the solar cell 1 to form the plurality of openings H for the formation of the first and second electrodes 141 and 142.

The transfer unit 230 may be disposed under the optical unit 220 and may be a convey belt. Thus, the transfer unit 230 may transfer the solar cell 1 in one direction.

The solar cell 1 according to the embodiment of the invention is a back contact solar cell, in which all of the first and second electrodes 141 and 142 are positioned on the back surface of the semiconductor substrate 110, on which light is not incident. An operation of the back contact solar cell 1 having the above-described structure is described below.

When light irradiated onto the solar cell 1 is incident on the semiconductor substrate 110, a plurality of electron-hole pairs is generated in the semiconductor substrate 110 by light energy produced based on the incident light. The electron-hole pairs are separated into electrons and holes due to the p-n junction between the semiconductor substrate 110 and the emitter regions 121. The separated holes move to the p-type emitter regions 121 and then are collected by the first electrodes 141, and the separated electrons move to the n-type back surface field regions 172 and then are collected by the second electrodes 142. When the first and second electrodes 141 and 142 are connected to each other using electric wires, current flows therein to thereby enable use of the current for electric power.

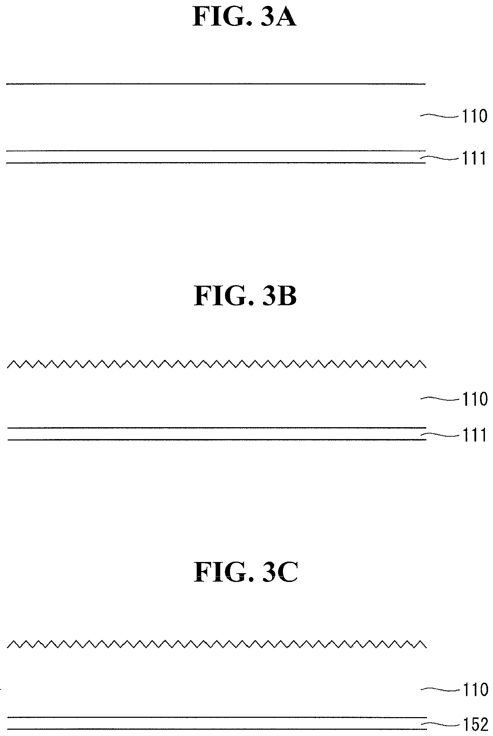

FIGS. 3A to 3J sequentially illustrate a method of manufacturing a solar cell shown in FIGS. 1 and 2.

As shown in FIG. 3A, a semiconductor substrate 110 formed of n-type single crystal silicon may be prepared, and an etch stop layer 111 formed of silicon oxide (SiOx), etc., may be stacked on one surface, for example, a back surface of the semiconductor substrate 110.

In this instance, the semiconductor substrate 110 may contain impurities of a first conductivity type or impurities of a second conductivity type opposite the first conductivity type. For example, the semiconductor substrate 110 may be a semiconductor substrate containing p-type impurities or n-type impurities.

Next, as shown in FIG. 3B, the other surface, for example, a front surface of the semiconductor substrate 110, on which the etch stop layer 111 is not formed, may be etched using the etch stop layer 111 as a mask to form a textured surface having a plurality of uneven portions on the front surface of the semiconductor substrate 110, on which light is incident. Then, the etch stop layer 111 may be removed. When the semiconductor substrate 110 is formed of single crystal silicon, the surface of the semiconductor substrate 110 may be textured using an alkaline solution, such as KOH, NaOH, and TMAH. On the other hand, if the semiconductor substrate 110 is formed of polycrystalline silicon, the surface of the semiconductor substrate 110 may be textured using an acid solution, such as HF and HNO₃.

Next, as shown in FIG. 3C, a control passivation layer 152 may be formed on the back surface of the n-type semiconductor substrate 110. The control passivation layer 152 may pass carriers produced in the semiconductor substrate 110 and may perform a passivation function with respect to the back surface of the semiconductor substrate 110.

The control passivation layer 152 may be formed of a dielectric material including silicon carbide (SiCx) or silicon oxide (SiOx) having strong durability at a high temperature equal to or higher than 600 °C.

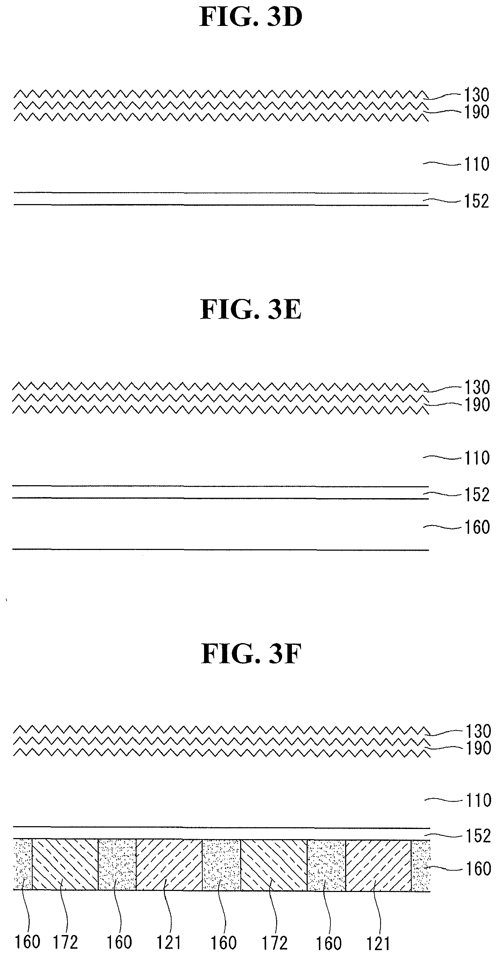

Next, as shown in FIG. 3D, a front passivation layer 190 and an anti-reflection layer 130 may be deposited on the front surface of the semiconductor substrate 110.

The front passivation layer 190 and the anti-reflection layer 130 may be formed on the front surface of the semiconductor substrate 110 using a stacking method, such as a CVD method and a PECVD method.

A refractive index of the anti-reflection layer 130 may be between a refractive index of air and a refractive index (for example, about 3.5) of the semiconductor substrate 110, for example, about 1.9 to 2.3. Hence, because a change in the refractive index from the air to the semiconductor substrate 110 is sequentially performed, an anti-reflection effect of the anti-reflection layer 130 can be improved.

The front passivation layer 190 and the anti-reflection layer 130 may have a single-layered structure or a multi-layered structure and may be formed of one of a-Si, SiOx, SiNx, SiON, SiCx, and SiCN or a combination thereof.

Next, as shown in FIG. 3E, an intrinsic semiconductor layer 160 may be deposited on a back surface of the control passivation layer 152.

The intrinsic semiconductor layer 160 may be formed on the back surface of the semiconductor substrate 110 using a stacking method, such as a CVD method and a PECVD method.

Next, as shown in FIG. 3F, an impurity doping material including impurities of a group III element such as boron (B) may be diffused into the intrinsic semiconductor layer 160 to form a plurality of emitter regions 121. Further, an impurity doping material including impurities of a group V element such as phosphorus (P) may be diffused into the intrinsic semiconductor layer 160 to form a plurality of back surface field regions 172.

More specifically, the plurality of emitter regions 121 has the second conductivity type opposite the first conductivity type of the semiconductor substrate 110. Hence, the semiconductor substrate 110 and the plurality of emitter regions 121 form a p-n junction. Further, because the semiconductor substrate 110 and the plurality of emitter regions 121 are formed of different semiconductor materials, the semiconductor substrate 110 and the plurality of emitter regions 121 form heterojunction.

Each of the plurality of back surface field regions 172 may be an impurity region having an impurity concentration higher than that of the semiconductor substrate 110. In this instance, formation order of the emitter regions 121 and the back surface field regions 172 may be changed.

The emitter regions 121 and the back surface field regions 172 may be formed through a process using laser doping, a process using laser patterning and laser doping, or a process using a diffusion barrier layer.

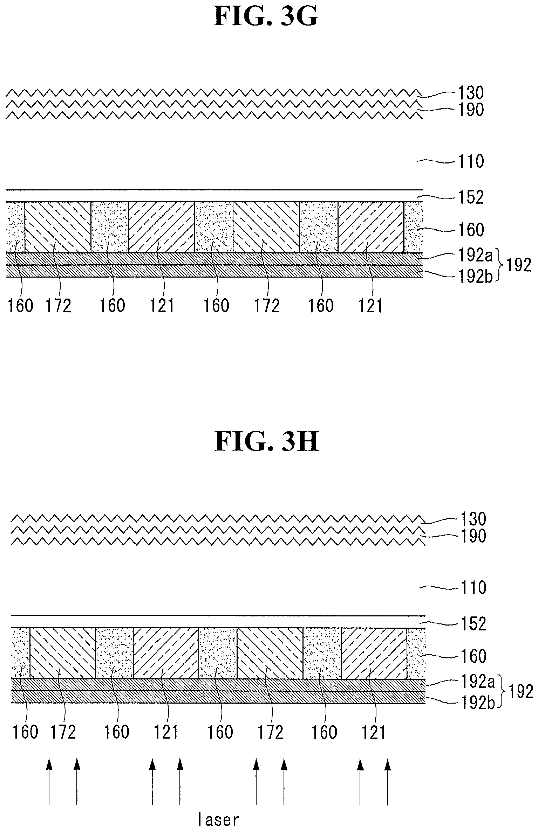

Next, as shown in FIG. 3G, a back passivation layer 192 may be deposited on the back surface of the semiconductor substrate 110.

More specifically, a first back passivation layer 192a may be deposited on the back surface of the semiconductor substrate 110, and then a second back passivation layer 192b may be deposited on a back surface of the first back passivation layer 192a to form the back passivation layer 192. Each of the first back passivation layer 192a and the second back passivation layer 192b may be formed of one of a-Si, SiOx, SiNx, SiON, SiCx, and SiCN or a combination thereof.

In this instance, the back passivation layer 192 may be formed through the same process as the front passivation layer 190 and may have a single-layered structure or a multi-layered structure.

Next, as shown in FIG. 3H, a solar cell 1 may be positioned on the transfer unit 230 of the laser irradiation device 2, and a laser may be selectively irradiated onto a portion of the back passivation layer 192 using the laser irradiation device 2.

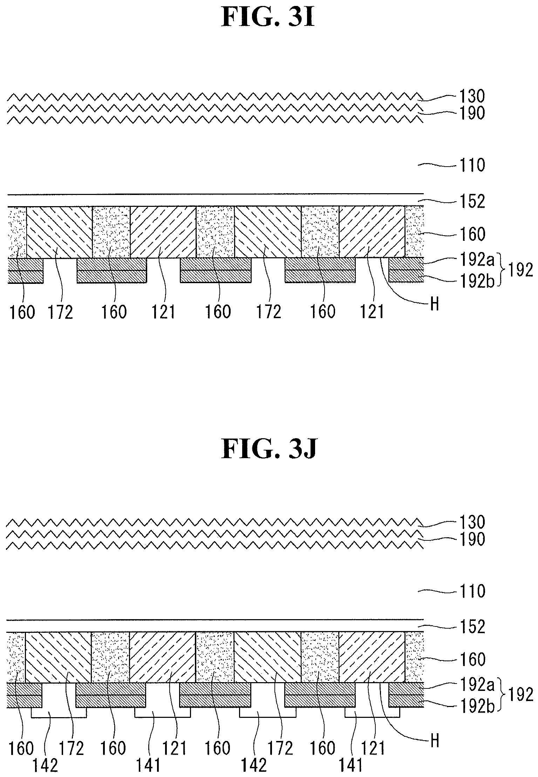

Next, as shown in FIG. 3I, a plurality of openings H may be formed in a portion of the back passivation layer 192 using laser ablation. Hence, the emitter regions 121 and the back surface field regions 172 may be exposed through the plurality of openings H.

The plurality of openings H may be formed in a connecting portion of the first electrode 141 and the emitter region 121 and a connecting portion of the second electrode 142 and the back surface field region 172 at the back surface of the semiconductor substrate 110. Hence, the electrical and physical connection between the first electrodes 141 and the emitter regions 121 and the electrical and physical connection between the second electrodes 142 and the back surface field regions 172 may be performed through the plurality of openings H.

Because the openings H are formed in a short time by selectively and continuously irradiating the laser at a uniform intensity using the laser irradiation device 2, the deterioration of characteristics of the semiconductor substrate 110 can be prevented or minimized.

In a relate art, a laser having pulses with asymmetric intensities (or non-uniform intensities) is irradiated to form openings. Hence, a semiconductor substrate was temporarily damaged to a great extent, and characteristics of a solar cell were deteriorated.

More specifically, when a laser having asymmetric pulses is used as in the related art, a first pulse generally has a peak energy and thus has a maximum intensity. As time passed, pulses of the laser have gradually decreasing intensities. Thus, because the semiconductor substrate is exposed to the peak energy of the first pulse, the semiconductor substrate is greatly damaged. Because the damage of the semiconductor substrate is generated by the use of the laser pulse having the peak energy, the semiconductor substrate may be damaged even if the laser is irradiated once.

On the other hand, in the embodiment of the invention, a total amount of laser energies is the same as that of the related art, but energy of each laser pulse is less than the peak energy of the related art. Hence, a damage to the semiconductor substrate can be reduced compared to the related art. Preferably, the embodiment of the invention is configured such that pulses of a laser have the same energy, and thus can efficiently reduce an intensity of each pulse of the laser while maintaining a total amount of laser energies as in the related art. As a result, the embodiment of the invention can more efficiently reduce the damage to the semiconductor substrate. In the embodiment of the invention, the total amount of laser energies refers to a sum of energies of pulses of the laser irradiated to form the openings.

The number of pulses of laser or a magnitude of energy of each pulse may be controlled depending on a material of the component, onto which the laser is irradiated. For example, because amorphous silicon has a thermal absorption coefficient greater than that of single crystal silicon, amorphous silicon receives more damage than single crystal silicon when a laser of pulses having the same energy is irradiated. Thus, laser pulses irradiated onto amorphous silicon may have energy lower than laser pulses irradiated onto single crystal silicon, and the number of laser pulses irradiated onto amorphous silicon may be more than the number of laser pulses irradiated onto single crystal silicon.

The following Table 1 shows experimental results of how much damage occurred in a comparative example, in which a laser of asymmetric intensity is used as in the related art, and an experimental example, in which a total amount of laser energies is the same as that of the related art, energy of each laser pulse is less than a peak energy of the comparative example, and the laser pulses have the same energy as in the embodiments of the invention. The experiments were carried out by measuring an open-circuit voltage before and after the laser irradiation. Values in the following Table 1 represent an open-circuit voltage difference before and after the laser irradiation.

As indicated by the following Table 1, an open-circuit voltage difference before and after the laser irradiation in comparative examples 1 to 3 were 4 mV, 6 mv, and 6 mV, respectively. On the other hand, an open-circuit voltage difference before and after the laser irradiation in experimental examples 1 to 3 were 3 mV, 3 mv, and 2 mV, respectively. Namely, the damage was efficiently reduced in the experimental examples according to the embodiments of the invention, compared to the comparative examples according to the related art.

**[Table 1]**

| No. | Comparative example | Experimental example |
|---|---|---|
| 1 | 4 mV | 3 mV |
| 2 | 6 mV | 3 mV |
| 3 | 6 mV | 2 mV |

Next, as shown in FIG. 3J, the first electrodes 141 connected to the emitter regions 121 may be formed through the openings H of the back passivation layer 192, and the second electrodes 142 connected to the back surface field regions 172 may be formed through the openings H of the back passivation layer 192.

A method of forming the first and second electrodes 141 and 142 may use any of a screen printing method and a plating method. However, it is preferable, but not required, that the first and second electrodes 141 and 142 are formed using the plating method in consideration of an alignment and an influence on the characteristics (for example, lifetime of carriers) of the semiconductor substrate 110 in a manufacturing process.

The first electrodes 141 and the second electrodes 142 may be formed to overlap a portion of the back passivation layer 192.

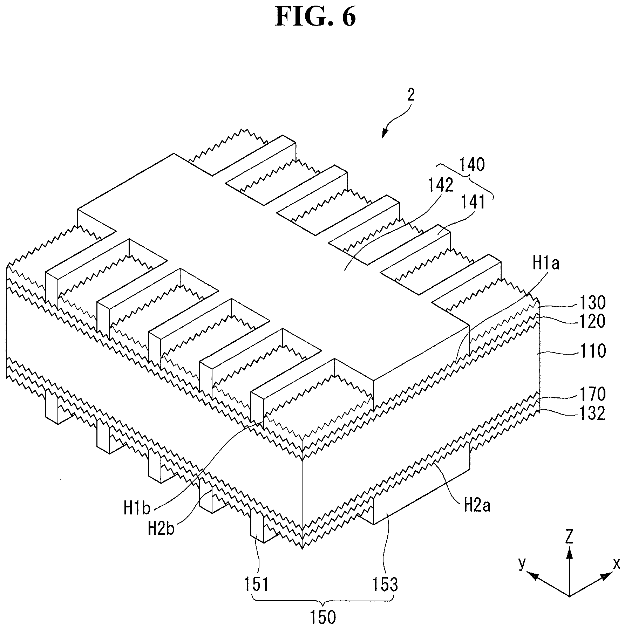

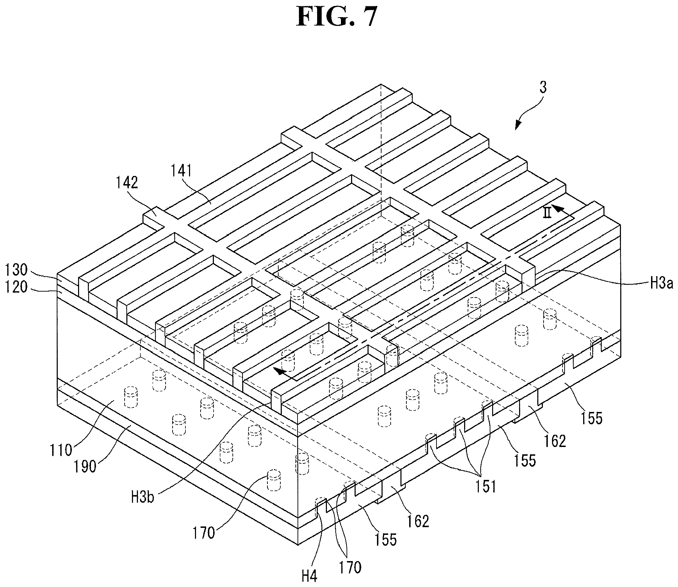

FIG. 6 and 7 illustrate other embodiments of a solar cell, to which the embodiment of the invention is applied.

FIG. 6 illustrates a solar cell according to a second embodiment of the invention.

As shown in FIG. 6, a solar cell 2 according to a second embodiment of the invention is a bifacial solar cell, that receives light through both a first surface and a second surface of a semiconductor substrate 110, and can generate electric current using light incident on the first surface and the second surface of the semiconductor substrate 110. Hence, a first electrode 140 may be formed on a front surface of the semiconductor substrate 110, and a second electrode 150 may be formed on a back surface of the semiconductor substrate 110.

In the second embodiment of the invention, unlike FIGS. 1 and 2, the first electrode 140 may include front fingers 141 extended in a first direction x and a front bus bar 142 extended in a second direction y intersecting an extending direction (i.e., the first direction x) of the front fingers 141.

Further, the second electrode 150 may include back fingers 151 that are spaced apart from one another on the back surface of the semiconductor substrate 110 and are extended in the first direction x, and a back bus bar 153 extended in the second direction y intersecting an extending direction (i.e., the first direction x) of the back fingers 151.

For example, the back fingers 151 of the second electrode 150 may be formed at a location corresponding to the front fingers 141 of the first electrode 140, and the back bus bar153 of the second electrode 150 may be formed at a location corresponding to the front bus bar 142 of the first electrode 140.

A plurality of first openings H1a and H1b may be formed in a first passivation layer on the front surface of the semiconductor substrate 110 using laser ablation, and a plurality of second openings H2a and H2b may be formed in a second passivation layer on the back surface of the semiconductor substrate 110 using the laser ablation.

The first electrode 140 may be formed at an emitter region 120 exposed by the first openings H1a and H1b, and the second electrode 150 may be formed at a back surface field region 170 exposed by the second openings H2a and H2b. Hence, the solar cell 2 may be completed.

FIG. 7 illustrates a solar cell according to a third embodiment of the invention.

A solar cell 3 according to a third embodiment of the invention may be a passivated emitter and rear cell (PERC).

Unlike FIGS. 1 and 2, the solar cell 3 according to the third embodiment of the invention may include a plurality of front electrodes 141 that are disposed on a front surface of a semiconductor substrate 110 and are electrically connected to an emitter region 120, and a plurality of front electrode current collectors 142 that are connected to the plurality of front electrodes 141 and are extended in a direction intersecting the plurality of front electrodes 141.

Further, the solar cell 3 according to the third embodiment of the invention may include a back electrode conductive layer 155 that is positioned on a passivation layer 190 on a back surface of the semiconductor substrate 110 and includes a plurality of back electrodes 151 electrically connected to the semiconductor substrate 110, a plurality of back electrode current collectors 162 that are positioned on the passivation layer 190 and are electrically connected to the back electrode conductive layer 155, and a plurality of back surface field regions 170 positioned between the plurality of back electrodes 151 and the semiconductor substrate 110.

In this instance, the passivation layer 190 may include at least one hole and contain intrinsic silicon.

An anti-reflection layer 130 on the front surface of the semiconductor substrate 110 may include a plurality of third openings H3a and H3b using laser ablation, and the passivation layer 190 on the back surface of the semiconductor substrate 110 may include a plurality of fourth openings H4 using the laser ablation.

Hence, the plurality of front electrodes 141 and the plurality of front electrode current collectors 142 may be formed on the emitter region 120 exposed by the plurality of third openings H3a and H3b, and the back electrode conductive layer 155 may be formed on the back surface of the semiconductor substrate 110 exposed by the plurality of fourth openings H4. As a result, the solar cell 2 may be completed.

The foregoing embodiments are merely examples and are not to be considered as limiting the present disclosure. The present teachings can be readily applied to other types of methods and apparatuses. The features, structures, methods, and other characteristics of the embodiments described herein may be combined in various ways to obtain additional and/or alternative embodiments.

Although embodiments have been described with reference to a number of illustrative embodiments thereof, it should be understood that numerous other modifications and embodiments can be devised by those skilled in the art that will fall within the scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A method of manufacturing a solar cell, the method comprising:
forming a control passivation layer on a back surface of a semiconductor substrate containing impurities of a first conductivity type;
forming an emitter region containing impurities of a second conductivity type opposite the first conductivity type and a back surface field region containing impurities of the first conductivity type on the control passivation layer;
forming a passivation layer on the emitter region and the back surface field region;
forming first and second openings in the passivation layer by using a pulse type laser having a continuously uniform intensity;
forming a first electrode electrically and physically connected to the emitter region through the first opening; and
forming a second electrode electrically and physically connected to the back surface field region through the second opening.

2. The method of claim 1, wherein the first and second openings are formed using a laser ablation method via the pulse type laser.

3. The method of claim 2, wherein a number of pulses of the laser is one to eight.

4. The method of claim 3, wherein the number of pulses of the laser is two to four.

5. The method of any one of claims 2 to 4, wherein an energy of the laser is about 0.1 J/cm² to 3 J/ cm².

6. The method of any one of claims 2 to 5, wherein a pulse width of the laser is about 10 ps to 15 ps.

7. The method of any one of claims 2 to 6, wherein a pulse gap of the laser is about 20 ns.

8. The method of any one preceding claim, wherein the passivation layer includes a first passivation layer formed of silicon oxide, SiOx, and a second passivation layer formed of silicon nitride, SiNx.

9. The method of any one preceding claim, wherein the passivation layer exposes a portion of the emitter region and a portion of the back surface field region through the first and second openings.

10. The method of any one preceding claim, wherein the passivation layer is formed in a remaining area excluding a connecting portion of the first electrode and the emitter region and a connecting portion of the second electrode and the back surface field region from the back surface of the semiconductor substrate.

11. The method of any one preceding claim, further comprising forming an intrinsic semiconductor layer on the control passivation layer,
wherein the emitter region and the back surface field region are formed in the intrinsic semiconductor layer.

12. The method of claim 11, wherein the intrinsic semiconductor layer includes polycrystalline silicon.

13. The method of any one preceding claim, wherein the emitter region and the back surface field region are formed using one of laser doping, laser patterning, and a diffusion barrier layer.

14. A method of manufacturing a solar cell, the method comprising:
forming an emitter region containing impurities of a second conductivity type opposite a first conductivity type and a back surface field region containing impurities of the first conductivity type on a semiconductor substrate containing impurities of the first conductive type;
forming a passivation layer on the emitter region and the back surface field region;
forming first and second openings in the passivation layer by using a pulse type laser having a first pulse and a second pulse that have uniform intensity with each other;
forming a first electrode connected to the emitter region at the first opening; and
forming a second electrode connected to the back surface field region at the second opening.

15. The method of claim 14, wherein a number of pulses of the laser is a plurality and wherein a number of the plurality of pulses of the laser is two to four.
